# EUROPEAN PATENT SPECIFICATION

(11) **EP 0 380 682 B1**
(45) Date of publication and mention of the grant of the patent: **19.04.1995**
(21) Application number: 89907275.5
(22) Date of filing: 15.06.1989
(51) Int. Cl.: H01L 21/203

(54) **METHOD OF FABRICATING SEMICONDUCTOR DEVICES**
VERFAHREN ZUR HERSTELLUNG VON HALBLEITERANORDNUNGEN
PROCEDE DE FABRICATION DE DISPOSITIFS A SEMI-CONDUCTEURS

(30) Priority: 17.06.1988 JP 150581/88
(43) Date of publication of application: 08.08.1990
(73) Proprietor: OHMI, Tadahiro, Sendai-shi Miyagi-ken 980 (JP)
(72) Inventor: OHMI, Tadahiro, Sendai-shi,Miyagi-ken 980 (JP); SHIBATA, Tadashi, Sendai-shi,Miyagi-ken 980 (JP); UMEDA, Masaru, Tokyo 103 (JP)
(74) Representative: Rees, David Christopher
(86) International application number: PCT/JP89/00599
(87) International publication number: WO 89/12909

(56) References cited:
- WO-A-87/07651
- JP-A- 5 462 776
- JP-A- 5 918 196
- JP-A-59 501 562
- JP-A-63 170 299
- PATENT ABSTRACTS OF JAPAN, vol. 7, no. 255 (E-210)[1400], 12th November 1983;& JP-A-58 140 111
- EXTENDED ABSTRACTS OF THE 20TH (1988 INTERNATIONAL) CONFERENCE ON SOLID STATEDEVICES AND MATERIALS, Tokyo, 1988, pages 49-52; T. OHMI et al.: "Very-low-temperature epitaxial silicon growth by low-kinetic-energy particlebombardment"

## Description

The present invention relates to a method for the manufacture of a semiconductor device, and particularly to a technique to form a thin film semiconductor element on a substrate.

In the past, various techniques have been developed to form a crystalline layer of a semiconductor on an insulating substrate and to form various types of devices on it. Particularly, the technique has been developed to form a monocrystal silicon layer on an insulator substrate and to form a semiconductor device on this to produce an integrated circuit, called SOI (Silicon on Insulator), and fervent research and development have been carried out in this area. If the SOI technique can be effected, it is not only advantageous for the production of high-speed ICs, but it will open the road towards the latch-up free CMOST circuit or towards dynamic memory with very high soft error tolerance. Also, it may be possible to achieve an IC of 3-dimensional structure by sequentially stacking up the semiconductor element through the insulating layer on the semiconductor element.

Further, if a monocrystal silicon layer can be built up at low cost on a glass substrate with a large area by the SOI technique, it is possible to provide a high-performance large-size flat panel type display unit. This could represent a radical innovation to display devices such as wall-hanging type television sets. Despite these great expectations, however, the SOI techniques is still far from being a practical application, and the development of the products based on such a technique may not be realised in the near future.

In the following, some problems will be described by giving some examples of SOI techniques.

The SOS (Silicon on Sapphire) technique is a technique known for many years. This is a technique to form a thin film of Si on sapphire (Al₂O₃) by epitaxial growth, and to form an IC. Despite practical application and commercial production for many years, this does not constitute the main stream of SOI technique and is applied only in limited application fields because the product cost of the sapphire substrate is higher than silicon wafer and because crystal defects occur due to the difference in the crystal lattice constants between sapphire and silicon, and it is difficult to produce a high-performance device.

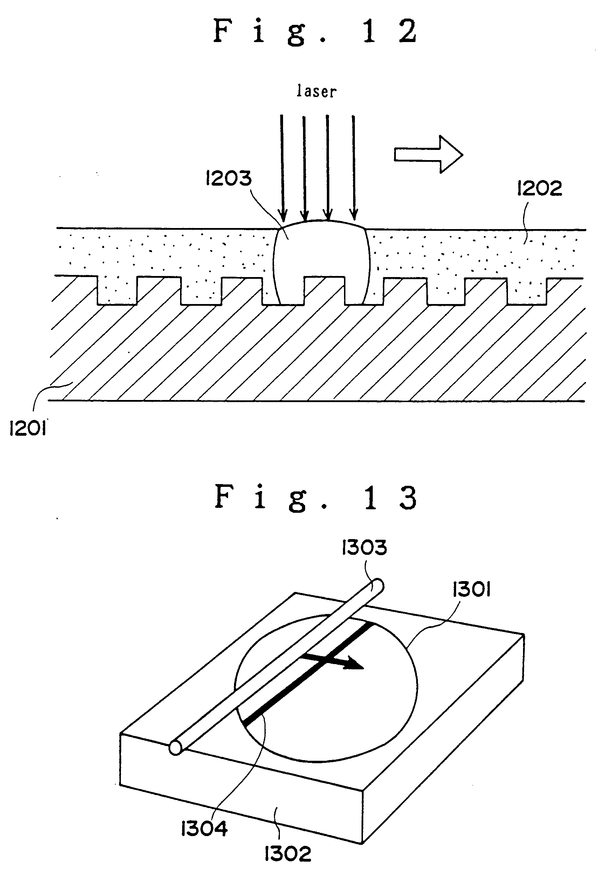

In contrast, new techniques have emerged in the last 10 years, by which a monocrystal silicon thin film is formed on an insulator substrate surface which has no crystal property, such as SiO₂, Si₃N4, AℓN, etc. The technique of graphic-epitaxy is one such new technique. As shown in Figure 12, grooves are formed periodically on the surface of an SiO₂ substrate 1201, and amorphous silicon 1202 is stacked on it. Then, a scanning laser beam is applied to the substrate to produce a partially melted region 1203, and the silicon is turned into a monocrystal. Once the silicon is melted, the grating pattern is formed on the surface of the substrate during recrystallisation. The crystals aligned to the direction of this pattern grow and all the surfaces are turned into a monocrystal. However, the crystal layers formed by this technique contain many crystal defects and could not be used for SOI devices.

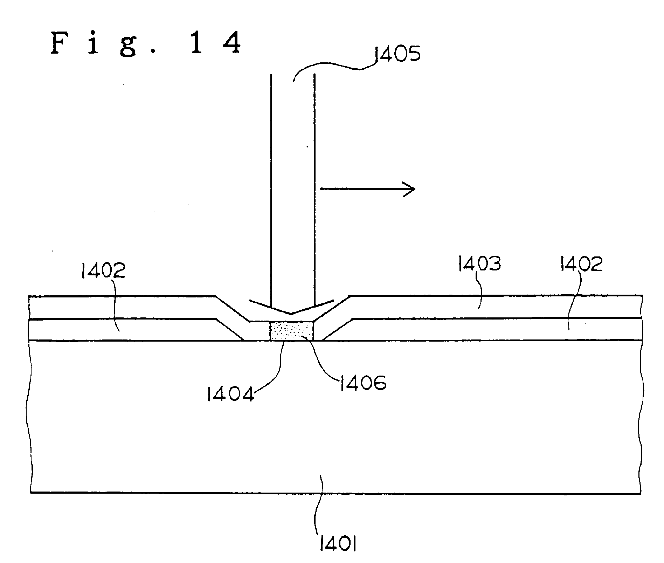

In the meantime, the zone melt method as shown in Figure 13 has been developed. In this method, the same wafer 1301 as in Figure 12 is placed on a stage 1302 and heated. By energising a long carbon heater 1303 and scanning, a linear melted region 1304 is formed on the wafer surface to produce a monocrystal thin film. By this method, however a good crystal cannot be obtained because of contamination by carbon from the carbon heater 1303. Also, wafer may be warped by heat or the Si thin film may be cracked, and the method has not been used in practice. The temperature of the wafer is partially increased to more than the melting point (1412°C) of silicon, and this method cannot be applied for a 3-dimensional IC. Devices built up on a base material may be melted during monocrystallisation of the upper silicon layer and extreme deterioration of the characteristics may occur.

An electron beam may be used as the heating means, but the results are not very satisfactory.

In addition to these methods to build up monocrystals using a grating pattern, there is a technique called lateral epitaxy as shown in Figure 14. By this method, an amorphous Si layer 1403 is stacked on a substrate 1401 with an intermediate SiO₂ film 1402, which is formed on the substrate 1401 of Si monocrystal. In this case, a part of the amorphous layer is brought into direct contact with the surface 1404 of the substrate 1401. Then, a laser beam 1405 is irradiated wafer to form the melted region 1406 of silicon. In this case, if the laser beam scanning is started from the monocrystal portion 1404, monocrystal growth is started from this portion and extends to the SiO₂ film 1402, and the monocrystal layer is formed on the insulating film. However, in this case, too, crystal defects occur as the beam moves away from the monocrystal region, and it is not yet possible to form a monocrystal silicon thin film of high quality over all the wafer surface.

The method of heating locally by laser beam is also not very recommendable because extensive thermal distortion occurs on the substrate. For this method, it is essential to have a monocrystal substrate of silicon because an insulator substrate is used, which is obtained by the thermal oxidation of the silicon substrate and by forming SiO₂ film on it. It is not possible to apply it for the formation of a monocrystal thin film on a glass substrate with a large area, as often seen in the manufacture of flat panel display units.

As described above, there are a number of problems in SOI techniques at present. These problems may be summarised as follows:

First, the temperature of the wafer is increased partially to more than the melting point of silicon 1412°C, because the Si is partially melted for recrystallisation. This is essentially incompatible with semiconductor device processes of the future, which are primarily oriented towards low temperatures. Specifically, various elements of IC's such as wiring, formed before recrystallisation, may be subjected to undesirable reactions by heat during the recrystallisation process, or the characteristics may be substantially deteriorated by extensive thermal strain.

Secondly, in cases where a sapphire substrate or a silicon substrate produced by thermal oxidation is used, the application to a large-size display unit is generally impossible. It is difficult to prepare a substrate of good quality have large area, and there is also the problem of the cost increase.

Thirdly, except for SOS techniques, crystal defects or contamination by impurities often occur in the crystal layer obtained by various SOI techniques, and it is not yet possible to produce ICs. For the practical application of SOI techniques, it is necessary to develop a system by which it is possible to form a monocrystal silicon layer of high quality on any insulator substrate through a simple process and at a low temperature.

To solve these problems, the present invention offers a method for manufacturing a semiconductor device, which can form a high-quality monocrystal semiconductor layer on any insulator substrate at a low temperature and by means of a simple process.

According to the invention, there is provided a method for manufacturing a semiconductor device which comprises forming an electrically conductive layer over at least a portion of the main surface of a substrate, the conductive layer defining a surface pattern including raised portions and indented portions, the junctions between the raised portions and the indented portions being in the form of a step which is generally perpendicular to the main surface of the substrate; and forming a monocrystalline silicon thin film by a sputtering method on the substrate while a DC potential is applied to the electrically conductive layer.

The main surface of the substrate may be formed with an insulating material, or formed with the electrically conductive substance. Preferably, the thin film is formed by sputtering using an inert gas when the semiconductor thin film is formed. Preferably, the lateral side of the graded steps of the conductive layer is formed in such manner that the surface of the lower step of the graded step portion is surrounded by a closed loop.

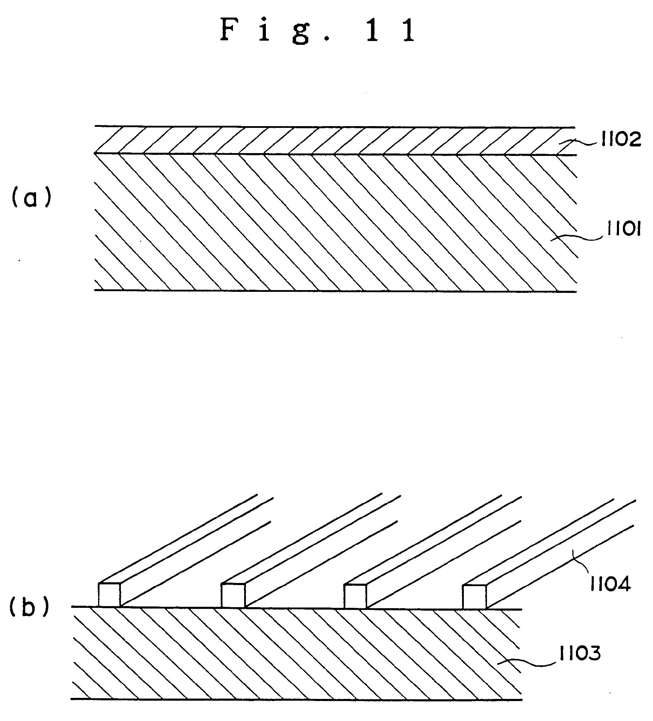

In this invention, an insulating substrate such as quartz substrate or glass substrate is used as the substrate. In addition, an AℓN substrate with a film of silicon nitride, SiO₂, etc. stacked on it (as shown in Figure 11) may be used as the substrate. Such a substrate has a high thermal conductivity, and the heat generated from the device at high speed operation can be effectively released. Naturally, an AℓN substrate alone may suffice. Furthermore, a sapphire substrate as used in the convention technique may suffice, whereas the most remarkable feature of the present invention is that a semiconductor monocrystal thin-film of good quality can be formed on a substrate such as quartz or glass, which are available at low cost.

It is also possible to apply this invention to an electrically conductive substrate. For example, an insulating substrate furnished with a thin metal film with graded steps or an insulator substrate with a recess in its surface and furnished with a thin metal film all over the surface may be used. In other words, the semiconductor monocrystal thin film can be grown on a metal thin film.

The electrically conductive layer with graded steps and formed on the main surface of the substrate may be for instance, a metal thin film pattern. The metal thin-film pattern may be formed as a square hole pattern. It may be fabricated in such manner that the pattern end surface is perpendicular to the substrate surface 202. Such fabrication can be performed by normal photo-lithography. On this conductive layer, the DC potential is applied when the semiconductor thin film is formed and the formation of the semiconductor thin film is controlled by this.

The size of the lattice pattern can be made as desired. Also, the shape of lattice pattern is not limited to a square hole pattern, but it may be a rectangular, regular hexagonal or regular triangular hole pattern. The shape of the lattice pattern is closely related to the crystallising direction of the semiconductor thin-film. For example, in a square hole pattern, the (100) face of the Si can be formed on the main surface of substrate, while the (111) face of the Si can be formed in a regular hexagonal or regular triangular hole pattern.

As the material for the electrically conductive layer, W is considered as the most preferable, but it is not limited to this. For instance, it may be another refractory metal or a refractory metal silicide. Naturally, it may be a metal, such as Al, Cu, Ni, Pd, Pt, Au, etc., but it is necessary to decrease the heat treatment temperature in order to prevent diffusion of these metals into the substrate during the manufacturing process.

In order to form the semiconductor thin film with DC potential applied on the conductive layer above, film formation by an RF-DC bonding bias sputtering device by the present inventor (Japanese Provisional Patent Publication Sho 62-287071) or sputtering film formation with bias under high frequency application on a quartz substrate holder may be applied.

In this system, the semiconductor thin film is controlled by the conductive layer having graded steps and by DC potential applied during the formation of semiconductor thin-film, and it is possible to obtain a semiconductor monocrystal thin-film of good quality.

The above description has referred to the case where a square pattern is used, but other patterns for the conductive layer may be used. The region surrounded by the conductive layer may be a regular hexagon or an equilateral triangle; both have triple symmetry. In cases where those patterns are used, the grown Si monocrystal layer has a (111) orientation.

The selection of (100) or (111) orientation may be made according to the condition of each device, while the results of experiments suggest that a film with (111) orientation has the better crystal property. Particularly, when the area of the portion surrounded by the W thin film pattern is increased to more than 1 cm x 1 cm, the difference becomes obvious. For example, the defect density value is lower in monocrystals of (111) face.

This may suggest some relationship with the phenomenon that the (111) face grows more easily if the thin film is grown by irradiating with ions. The detailed mechanism of this phenomenon is not yet known, however it may be interpreted that the Si thin film grows in such a way that the most dense face and the strongest to ion irradiation, i.e. the Si (111) face, is turned perpendicularly to the direction of ion irradiation. In other words, the monocrystal of (111) face grows because the ion irradiation itself has the property of aligning the thin film to the (111) orientation and the three-way symmetry patterns play a role in determining the orientation within the plane. Therefore, it is more natural to grow (111) Si rather than to grow (100) Si against the effect of this ion irradiation. Thus, a thin film with a high crystal property is obtained.

As the result of this invention, a monocrystal semiconductor layer of high quality can be formed easily on any type of substrate by means of a low temperature process. Thus, ultra-high speed semiconductor devices and high-performance flat panel display unit, etc. can be manufactured.

The invention may be carried into practice in various ways and some embodiments will now be described by way of example with reference to Figures 1 to 11 of the accompanying drawings, in which:-
Figures 1 (a) - (d) are sectional views of a first embodiment of the invention;
Figures 2 (a) and (b) are a plan and a sectional view respectively of a W thin film pattern of the first embodiment;
Figure 3 is a schematic view of an RF-DC bonding bias sputtering unit;
Figure 4 (a) - (c) are successive views showing the mechanism of crystal growth;
Figures 5 (a) and (b) are the schematic diagrams of the other examples showing the configuration of the apparatus around the high frequency power source of the RF-DC bonding bias sputtering unit;
Figures 6 (a) and (b) are plan views showing alternative examples of the W thin film pattern;
Figures 7 (a) - (d) are sectional views of processes according to Embodiments 2 to 5;
Figures 8 (a) and (b) are sectional views for Embodiments 6 and 7;
Figure 9 (a) - (g) are the plan views and sectional views showing the process and the composition of Embodiment 7;
Figure 10 is a sectional view of Embodiment 8; and
Figures 11 (a) and (b) are a sectional view and a perspective view respectively of another example of the substrate and the metal pattern used in this invention.

As will have been understood, Figures 12 to 14 illustrate conventional methods. Figure 12 is a sectional view showing the grapho-epitaxy technique, Figure 13 is a perspective view of the zone melt method, and Figure 14 is a sectional view of the lateral epitaxy technique.

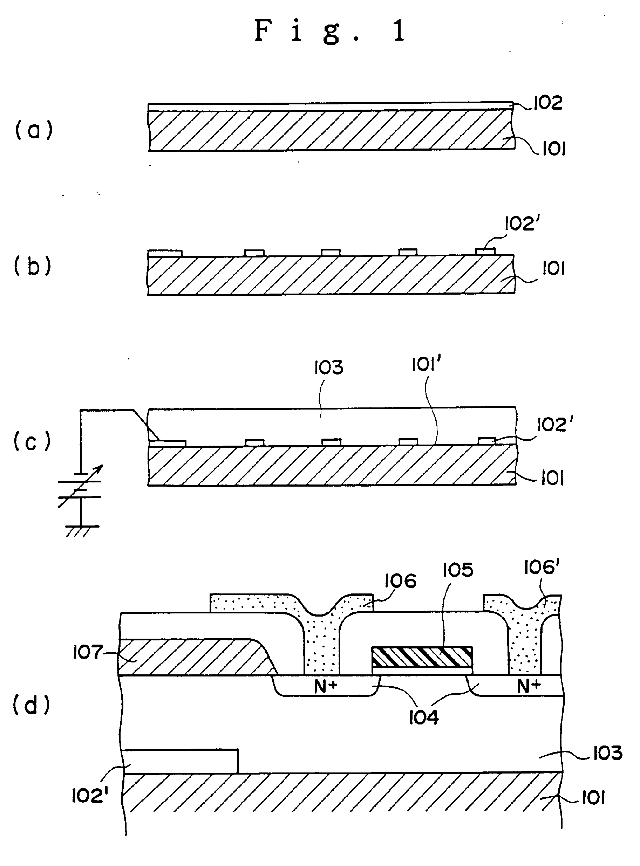

Figures 1 (a) - (d) are sectional views of a process according to Embodiment 1 of this invention. As shown in Figure 1 (a), a metal thin-film 102 of tungsten (w) is formed on the surface 101′ of a quartz substrate 101 with a thickness of about 50 nm. To form this film, EB (electron beam) vacuum evaporation may be used. In order to obtain the metal thin film with denser and higher crystal properties, it is more effective to perform the film formation by an RF-DC bonding bias sputtering device (Japanese Provisional Patent Publication Sho 62-287071 of the present inventor) or by sputtering film formation by applying bias under high frequency on a quartz substrate holder by the above device.

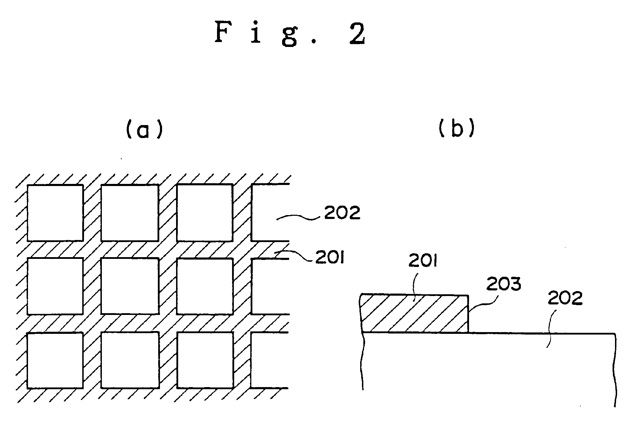

Next, the thin film 102 is fabricated in a pattern 102′ of the desired shape by photo-lithography (Figure 1 (b)). For the planar shape of this pattern, a thin film having a square hole pattern was arranged in a lattice as in the thin film pattern 201 of Figure 2 (a). In Figure 2 (a), the portion marked with oblique lines is the W thin film portion. As shown in Figure 2 (b), it is preferable to fabricate in such manner that the pattern end surface 203 forms steps approximately perpendicular to the substrate surface 202. Such fabrication can be performed by reactive ion etching (RIE).

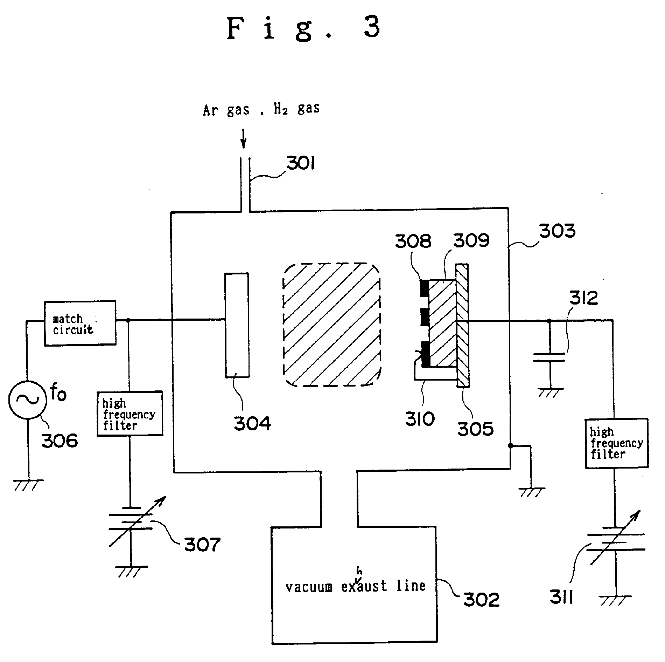

Next, as shown in Figure 1 (c), Si is stacked to about 0.1 to 0.5 »m by sputtering while DC potential is applied to the W thin film. This is done by a RF-DC bonding bias sputtering device (Japanese Provisional Patent Publication Sho 62-287071) as shown in Figure 3.

In this embodiment, the temperature of the substrate was set to 320°C, RF power to 20W, target bias to -300V, wafer holder bias to -5V, and Ar gas pressure to 1.1 Pa (8 x 10⁻³ Torr). Thus, a Si monocrystal film 103 could be formed all over the surface portion 101′ at a film forming speed of about 20 nm/min (Figure 1 (c)). It was found that the Si monocrystal film 103 thus obtained has a (100) face in parallel with the surface of substrate and that the crystals are aligned in the (110) direction in parallel on one side of the square pattern (Figure 2) (a)). This monocrystal thin film had almost no contamination due to crystal defects or impurities and was in very good condition.

Next, Figure 1 (d) shows an example, in which a MOSFET was formed in a monocrystal silicon film 103 through normal process. Figure 1 (d) is a schematic representation in which the portion near the thin film pattern is enlarged and shows the formation of an n-channel MOSFET. In Figure 1 (d), 103 refers to a p-type monocrystal silicon layer, 104 a source drain unit, 105 a gate electrode, 106 and 106′ A` wiring, 107 a field oxidation film, 101 a quartz substrate, and 102′ a W thin film pattern.

This W thin film pattern 102′ is a pattern, which is needed only for the purpose of supplying DC potential and controlling crystal growth when the monocrystal silicon is grown on the quartz substrate 101. For example, it may be removed together with silicon layer after the monocrystal film 103 of Figure 1 (c) has grown. Alternatively, it may be left to the last moment as shown in Figure 1 (d), and it may be used as an electrode for potential control of the monocrystal film 103, as a semiconductor layer of MOSFET.

The size of the lattice pattern shown in Figure 2 (a) can be changed as desired. For example, the width of the W thin-film pattern 201 with W left was set to the square of the portion, and without W of the substrate surface 202 was set to 5 mm. In so doing, it is possible to use a monocrystal region of 5 mm square as one chip, to prepare an LSI circuit, and to use the W thin film pattern 201 as the region for wafer dicing, i.e. as a dicing line. Naturally, both the pattern width and the square pattern may be reduced or enlarged.

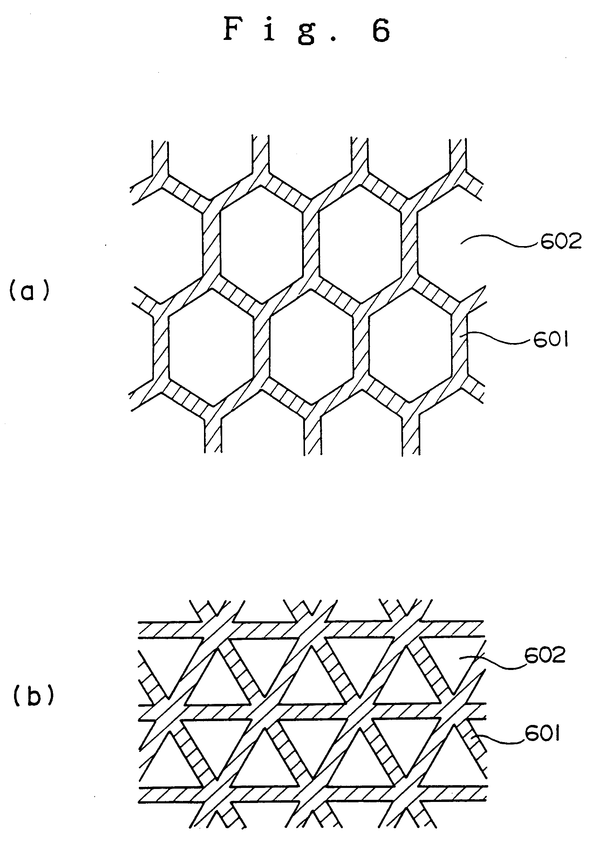

Here, the shape of the pattern and the sectional shape of the graded step is of primary importance. For example, a square pattern is adopted as the shape of the pattern, and Si monocrystal of (100) face grows. The same applies to a rectangular pattern. Also, if a pattern such as shown in Figure 6 (a) or Figure 6 (b) is used, the (111) face grows. In Figures 6 (a) and (b), 601 is the W thin film pattern, and 602 a substrate surface.

With regard to the sectional shape of the graded step, it is important that the graded step of the conductive material has its lateral side almost perpendicular to main surface of the substrate as shown in Figure 2 (b). It is known that the shape of the step largely determines the crystal property of the monocrystal thin film thus formed. However, there is no need to be accurately perpendicular. It may be tapered in such manner that the angle of the lateral side measured from the substrate surface 202, which is main plane of the substrate, is 90° ± 20° at maximum.

Although W was used as the conductive thin film in this embodiment, the material is not limited to this. For example, some other refractory metal or refractory metal silicide may be used. Naturally, Al, Cu, Ni, Pd, Pt, Au, etc. may be used, but it is necessary to decrease the heat treatment temperature in order to prevent diffusion of these metals into the substrate during the subsequent device manufacturing process. In cases where a refractory metal silicide is used, there is no problem such with any reaction between the conductive pattern 102′ and Si monocrystal film 103 or the diffusion of metal atoms even when a high temperature treatment of about 1000°C is performed during the semiconductor device manufacturing process.

As described above, it is possible by the method of this invention to activate the surface of Si thin film by utilising the impact of particles having a relatively low energy of about 20 - 30 eV and to obtain a good Si monocrystal thin film through a low temperature process for recrystallisation of Si. That is, the temperature of the substrate during the process is fixed by the temperature determined by the heating of the substrate. In Embodiment 1, the substrate temperature was set to 350°C, whereas this temperature may be lower or may be higher if necessary. In any case, because the recrystallisation is performed at a temperature far lower than 1412°C, the melting point of Si, no thermal strain occurs, and very few problems such as contamination arise. Accordingly, a thin film with excellent crystal properties can be obtained.

Also, there is no need to heat the base material to a high temperature, and the method can be easily applied to a 3-dimensional IC, which is formed by stacking the element in many layers. Furthermore, it is not necessary to use an expensive substrate such as sapphire, Si monocrystal substrate, etc., a semiconductor monocrystal of good quality can be obtained with an inexpensive substrate such as glass. Also, the device of Figure 3 can be produced in large sizes, and it is possible to produce a high-performance large-size flat panel display unit by growing a silicon monocrystal on the glass substrate of about 10 cm square and by combining it with a liquid crystal display.

As described above, Embodiment 1 of this invention has a number of excellent features compared with conventional techniques.

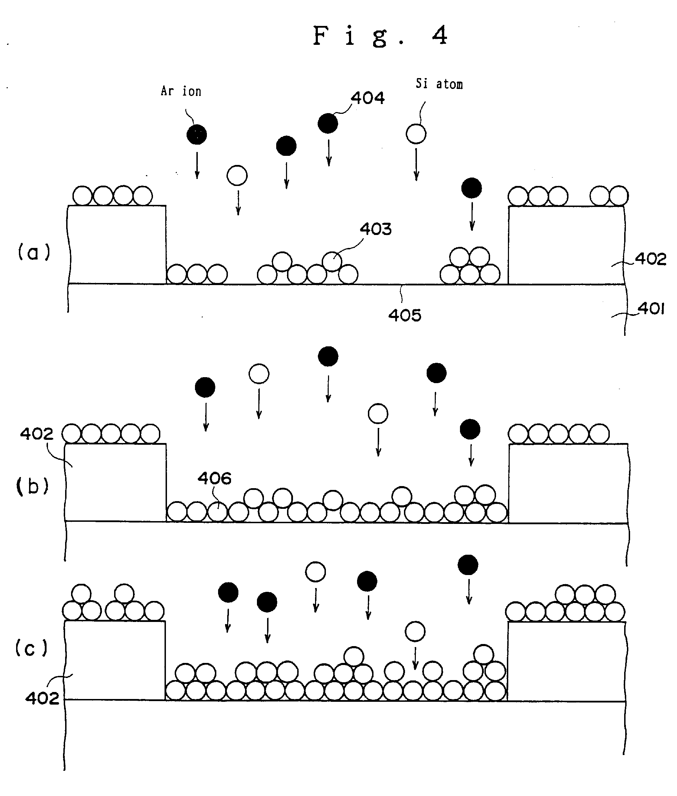

In Embodiment 1, the patterning of the metal thin film was performed on the insulator substrate as shown in Figure 1 (b). The stepped shape of the metal film was formed by completely removing the film in the monocrystal silicon forming region. As is evident from the description for Figures 4 (a) and (b), the stepped form is essentially important in order to obtain a semiconductor monocrystal of good quality, while the orientation of the crystal can be determined by pattern or shape of the exposed regions of the substrate.

A mechanism for forming a semiconductor monocrystal thin film on the surface of the substrate by the process of this invention, will now be described. To apply the DC potential, an RF-DC bonding bias sputtering device (Japanese Provisional Patent Application Sho 62-287071) as shown in Figure 3 is a preferable example. This device consists of a vacuum chamber 303 furnished with a gas supply system 301 to supply ultra-high purity Ar gas and H₂ gas and also furnished with an ultra-high vacuum exhaust system 302. A target 304 and a wafer holder 305 are installed in this chamber. In this case, a silicon block with a fixed quantity of added impurities such as As, P, B, etc. is used as the target 304, and a high frequency power source 306 of 100 MHz is connected from outside. Also, a DC power source 307 is connected to the target through a high frequency filter (low pass filter). The quartz substrate 309 with a W thin film pattern 308 is fixed on the wafer holder 305 and is electrically connected with the W thin film pattern 308 through a pin 310. Therefore, the potential of the W thin film pattern is a controlled DC power source 311 connected through a high frequency filter from outside.

The important parameters for thin film formation such as the quantity of Ar ions irradiated on the thin film surface during growth, the kinetic energy of individual ions, etc. can be freely and independently controlled together with the film forming rate of thin film. Specifically, the density of plasma, i.e. the concentration of generated Ar ions can be determined by the power of the high frequency source 306. On the other hand, the sputtering field of the target can be determined by the DC potential of the target. The film forming rate is determined by the combination of this high frequency power and DC bias value of the target. This is because the kinetic energy of the ions irradiated on the target and the quantity of ions can be independently controlled. By controlling the DC potential of the wafer holder, the energy of the Ar ions irradiated on the Si-thin-film surface during growth is determined, and the quantity of irradiated ions can be determined by controlling the high frequency power. By these functions, it is possible to control freely the crystallographic property of thin film stacked on the substrate 309.

In a preferred example, a semiconductor thin film is stacked on a substrate having the metal thin film pattern of Figure 2 in the device of Figure 3.

Figure 4 (a) to (c) are schematic drawings to explain the mechanism of crystal growth, where 401 refers to a quartz substrate, 402 a W metal thin film, 403 a Si atom, and 404 Ar ions. The conditions for stacking are: RF power 20W, target bias -300V, wafer holding bias -5V, and Ar gas pressure 1.1 Pa (8 x 10-3 Torr). The results of the experiment reveal that the floating potential of the surface of the insulator substrate is about OV and the potential of the plasma is about +20V under these conditions. The values of the potential are determined according to the characteristics of each individual device, the shape of the device, etc., and this setting condition is only an example.

Figure 4 (a) shows schematically the conditions at an early stage when the Si thin film is being formed. Before forming the film, RF power was set to about 5W, the target potential to about -20 to -30V, the wafer potential to 5 - 10V, and Ar ions and H ions were irradiated on the surface of the plasma, and the adsorbed moisture and carbon were removed. Si atoms sputtered at the target reach the substrate surface 405, attach and stack there. Naturally, they also attach and stack on the W thin film 402. At the same time, Ar ions also come to the substrate surface and irradiate the surface of the substrate or the stacked Si surface. The irradiation energy of Ar ions is equal to the potential difference between the plasma and substrate surface, and it is about 20 eV in this case. By this energy, nuclear generation on the substrate surface and Si atom migration are activated, and the growth of the Si crystals is accelerated. In the early stage of the Si thin-film formation, crystal grains having various orientations grow in small isles as shown in Figure 4 (a).

Figure 4 (b) shows the conditions in which the crystal grains grown so far are formed in a continuous film all over the surface of the substrate surrounded by the W thin film pattern 402. Under such conditions, the Si thin film 406 is electrically connected with the W thin film 402, and the potential becomes equal to the bias potential -5V of the wafer holder. Accordingly, the Si thin film is irradiated by Ar ions with energy of about 25 eV from this moment. By the irradiation with Ar ions with this energy, the bonding between Si atoms all over the stacked Si thin film ceases to exist, and each of Si atoms can freely move.

Further, when the Si atoms move about and the film thickness of the thin film increases, the kinetic energy of Ar ions given to the Si atoms in the lowermost layer is gradually decreased, and crystallisation begins sequentially from the lowermost layer. If patterns as shown in Figure 2 (a) and (b) are used, for example, the (100) face of Si grows. This may be because re-arrangement occurs in order to minimise the free energy of the entire film in contrast to the macroscopic shape of the W thin film 402. This is schematically illustrated in Figure 4 (c).

The thickness of the Si thin film increases thereafter as time elapses. In the zone several atoms deep at the uppermost surface region, the very active condition, i.e. the condition with free movement of atoms, is maintained, and the crystallisation proceeds sequentially from the lower layers. It is not certain how many of Si atomic layers at the surface experience free movement of the atoms because this will depend upon the growing speed of the thin film, the irradiation quantity of Ar ions, irradiation energy, etc. Under the condition as described above, it is approximately several atom layers.

In this example, the potential of the surface 405 of the quartz substrate 401 with its insulating property was set to approximately OV. This is approximately equal to the DC potential of the chamber because the wafer holder was earthed at high frequency by the capacitor 312 in the device of Figure 3 and the wafer potential was not oscillated with high frequency.

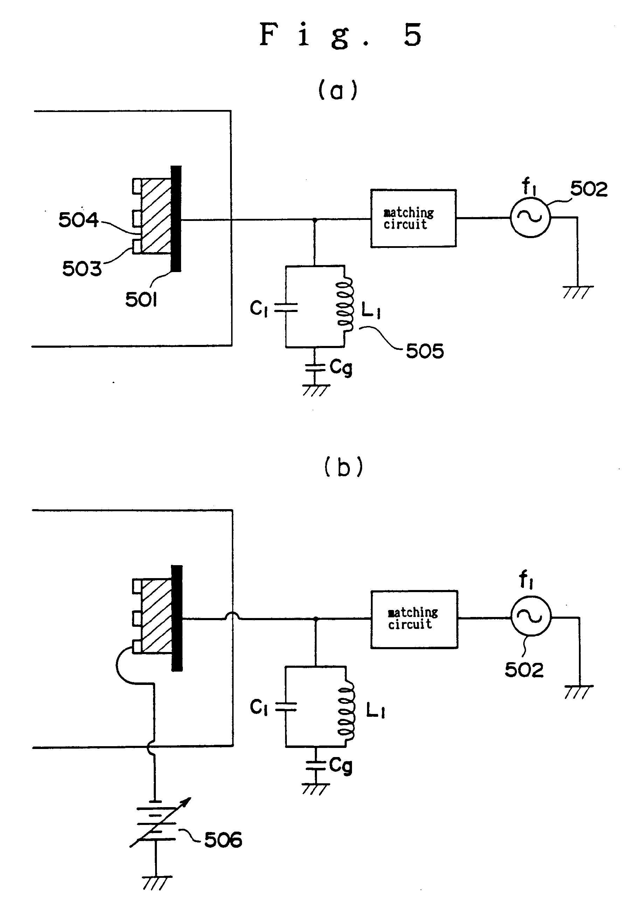

In this case, the high frequency source 502 may be connected to the wafer holder 501 as shown in Figure 5 (a). Then, the same DC potential is given to the W thin film 503 and the substrate surface 504. The value of this potential is determined by the frequency f₁ of the high frequency power, the Ar gas pressure, etc., and it is possible to make it to the desired value by changing the high frequency power.

The frequency f₁ of high frequency source applied on the wafer holder is different from the frequency f₀ of the high frequency source which generates discharge within the chamber. Because the power is only to give a DC potential, it is extremely low compared with the power f₀ to excite the discharge. 505 is a filter showing high impedance to the frequency f1 and showing very low impedance to f₀. Figure 5 (a) gives parallel circuits of L and C. The resonance frequency (2π (L₁C₁)1/2)-1 is set to a value equal to f₁. C_{g} is to cut off the wafer holder from grounding so that the DC potential is generated on the wafer holder, and C_{g} is set at a sufficiently high value so that (2π f₀C_{g})-1 and (2π f₁C_{g})-1 become sufficiently low. Of course, a LC serial resonance circuit can be used effectively to attain the same purpose. In this case, the resonance frequency (2π (LC)1/2)-1 is set to a value equal to f₀.

As explained in connection with Figure 3, if the potential of substrate surface and the potential of the W thin film are to be set to different values and to be controlled, the system of Figure 5 (b) may be used. Then, the irradiation energy E₁ of the Ar ions up until the Si thin film covers all surfaces of the substrate, and the irradiation energy E₂ after such covering, can be separately controlled by the power of the external high frequency source 502 and the voltage of the DC power source 506. The surface can be cleaned by Ar ion irradiation at a lower energy by reducing E₁ sufficiently, and crystal growth can be achieved with the optimal energy value E₂. On the contrary, it is also possible to activate the condition of the substrate surface until a connecting film is formed by increasing E₁ and to switch over automatically to the optimal energy for recrystallisation as soon as the connecting film is formed. If the specific resistance of thin film crystal is high or the potential control of the Si thin film cannot be achieved adequately due to the reverse bias property of the Schottky diode, it is preferable to follow the procedure of Figure 5 (a).

It is desirable to set the frequency f₁ of the high frequency source 502 to a value different from the frequency f₀ of the target high frequency source 306 (Figure 3). For example, 205 MHz may be used. Also, it is necessary to connect a LC antiresonant circuit such as 505 in place of the capacitor 312 (Figure 3). The resonance frequency of this circuit is equal to f₁, and it has infinite impedance to the high frequency of f₁. At the same time, it is important to set C₁ to such value that it may have sufficiently low impedance to the frequency f₀ of the high frequency source of the target.

### (Embodiment 2)

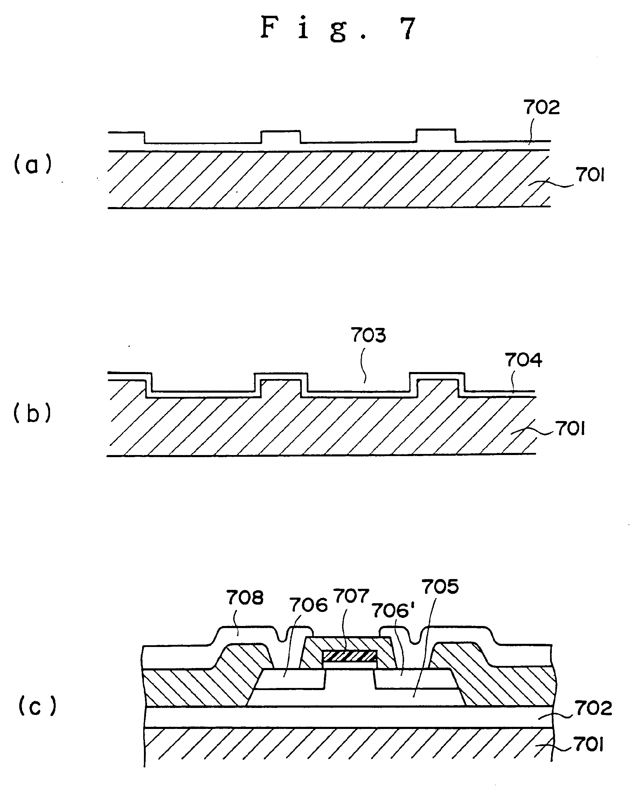

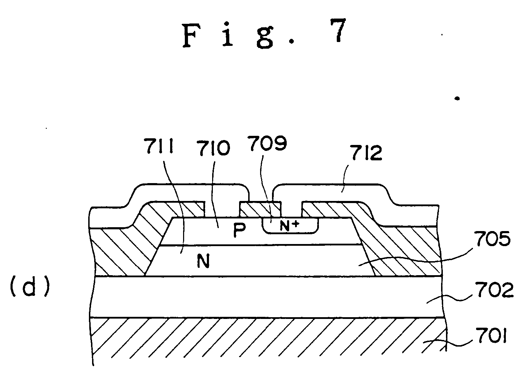

Figure 7 (a) is a sectional view of Embodiment 2 based on this invention. For example, after forming the metal thin film 702 of about 100 nm on the insulator substrate 701 which may be quartz, the graded shape of metal is obtained by the etching of about 60 nm using reactive ion etching with the resist as mask. It is also possible to grow a monocrystal silicon layer through the same process as in Figure 1 (c) for Embodiment 1 when a graded step as shown here is used. That is, the monocrystal silicon layer can be grown on a metal thin film. The remainder is the same as Embodiment 1.

### (Embodiment 3)

Figures 7 (b) is a sectional view of Embodiment 3 of this invention. A recess 703 is formed in the surface of the insulator substrate 701 by reactive ion etching, and the metal thin film 704 is formed all over the surface. It is possible to grow the monocrystal silicon layer by the same procedure as described in Figure 1 (c) for Embodiment 1, using the shape of the graded step as shown here. That is, the monocrystal silicon layer can be grown on a metal thin film. The remainder is the same as Embodiment 1.

### (Embodiment 4)

Figure 7 (c) is a sectional view of Embodiment 4 of this invention, in which a MOSFET was prepared in a monocrystal Si layer 705 formed on the metal thin film 702. 706 and 706′ are the source drain units, 707 a gate unit, and 708 metal wiring. The metal thin film 702 can be used for potential control of the MOSFET substrate. For example, it is possible to prevent the occurrence of abnormal electric current due to the floating effect of the substrate, which often causes trouble in the case of SOI MOSFET.

### (Embodiment 5)

Figure 7 (d) is a sectional view of Embodiment 5 of this invention, in which a bipolar transistor is manufactured in a monocrystal silicon layer 705 formed on the metal thin film 702. 709 refers to an emitter, 710 a base, 711 a collector, and 712 aluminium wiring. In this case, it is also effective to grow the high concentration region (e.g. n⁺ region) on a metal thin film, which is to become the collector electrode, for 0.02 to 0.1 »m, and to grow the high resistance region (e.g. n⁻ region) with a thickness as desired.

With the bipolar transistor prepared by the method of this invention, it is possible to produce a collector layer 711 thin enough and to take out the collector electrode directly to outside by the metal wiring 702. Thus, the serial resistance at the collector unit can be reduced to a full extent. Moreover, the film such as n⁺, n⁻², p⁺, p⁻, etc. can be grown at a temperature as low as 300 to 320°C. Accordingly, no trouble due to the distribution of impurities occurs, and it is most suitable for ultrahigh speed bipolar SLI. At the same time, when a metal is used as 701 instead of an insulator, the serial resistance of the collector decreases considerably, and thermal resistance is also reduced. Thus, it is possible to improve dramatically the characteristics of a high frequency power transistor or a transistor of micro-wave and milli-wave.

### (Embodiment 6)

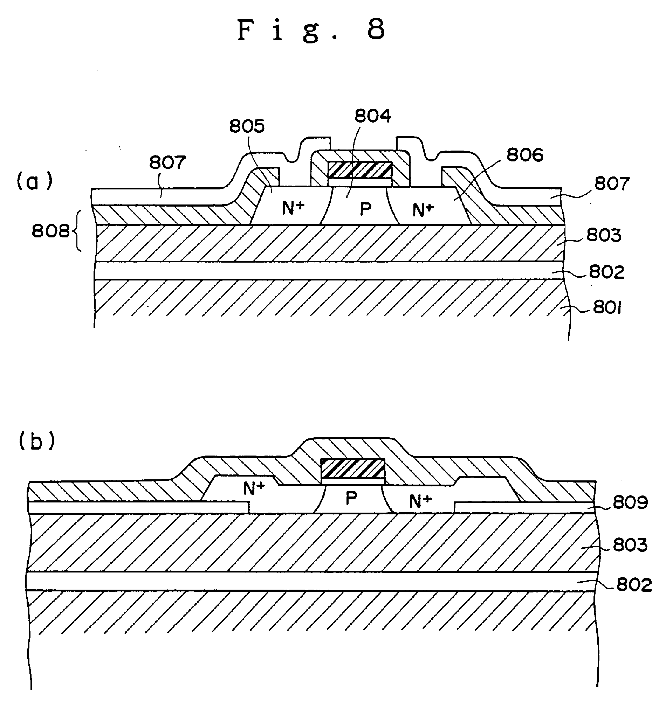

Figure 8 (a) is a sectional view of an MOS transistor, which is Embodiment 6 of this invention. The metal thin film 802 of about 0.5 »m is furnished on the substrate 801 of the insulator, and an SiO₂ film 803 is formed on it by 2-frequency excitation bias sputtering. Then, a monocrystal silicon layer is formed by the method of this invention, and the MOSFET is formed on it. The MOSFET with Si substrate 804 completely floated is called a "current overshoot transistor". In contrast to the gate input pulse, which rises up with high speed, the pn junction between the source unit 805 and the Si substrate 804 is momentarily biased forward, and a large quantity of electrons can be passed from the source unit 805 to the drain unit 806. This is a switching element with lower power consumption and is capable of operating at a speed as high as that of a bipolar transistor. The only wiring structure capable of propagating an ultrahigh speed signal to drive such transistor and to minimise crosstalk is the so-called metal-on-metal (M-O-M) structure as shown in the same figure, in which the metal wiring 807 runs over the metal electrode 802 through the insulating layer 808. Thus, the present invention offers for the first time a device, which can cope with ultra-high speed operation in both the device and wiring structure.

### (Embodiment 7)

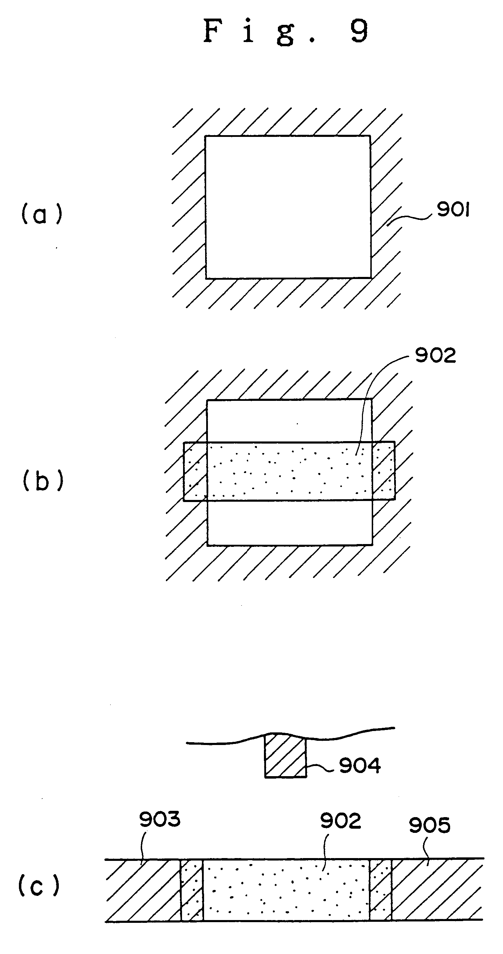

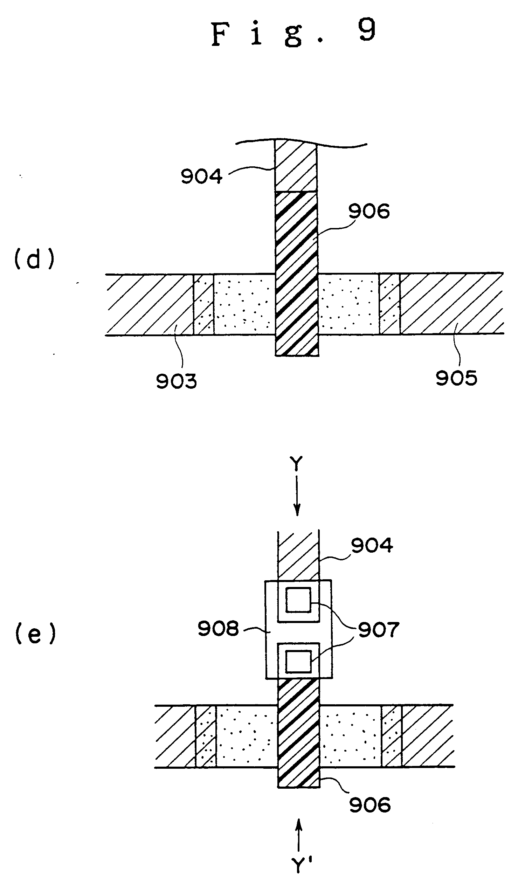

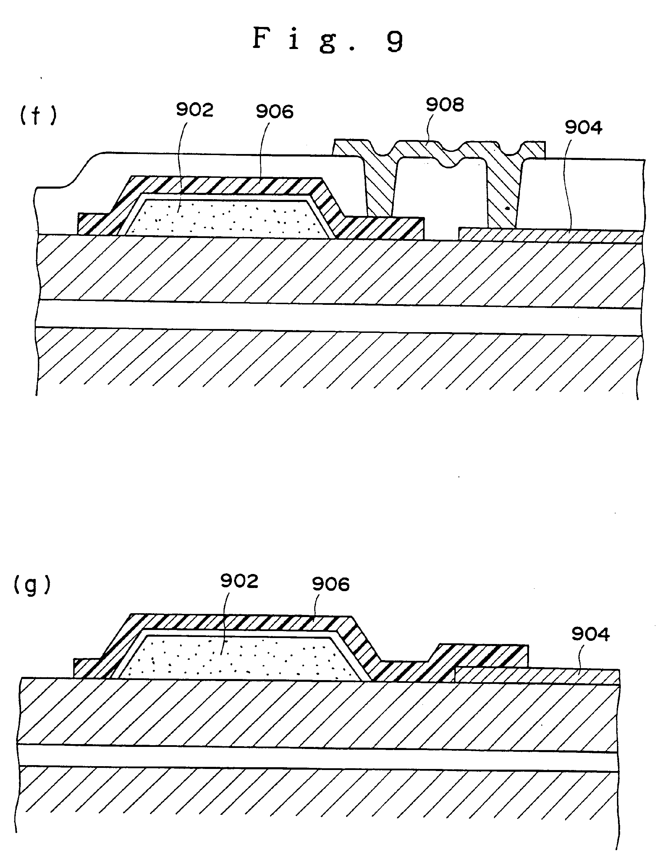

Figure 8 (b) is a section view showing the structure of Embodiment 7 of this invention, in which a current overshoot transistor and wiring of and MOM structure are realised at the same time. In this case, the metal thin film layer 809 used for the preparation of the monocrystal Si layer is used as a wiring electrode. Figure 9 is a plan of a manufacturing process of the device with this structure. As shown in Figure 9 (a), the metal thin film 901 is furnished on the surface of the insulator substrate, and a rectangular opening is provided. Then, a monocrystal Si layer is formed by the same process as in Figure 1 (c), and the Si thin film 902 is left only on the portion, which is turned to the transistor (Figure 9 (b)). Then, only the drawing or circuit wiring patterns of source-gate-drain (903, 904 and 905 respectively) are left, and the remaining metal films are removed by etching (Figure 9 (c)). Finally, after performing gate oxidation, the metal gate electrode 906 is formed (Figure 9 (d)), and the MOS transistbr of Figure 8 (b) is completed.

Poliside is used instead of the metal electrode as the gate, and the gate electrode is not directly connected with the gate drawing wiring 904. After forming the insulating film all over the surface, for example, the gate electrode and the gate drawing wiring 904 are connected by the wiring 908 through the contact hole 907 (Figure 9 (e)). The sectional view at Y - Y′ of this structure is given in Figure 9 (f). Figure 9 (g) is an example of the direct connection of the gate electrode 906 with the gate drawing wiring 904.

### (Embodiment 8)

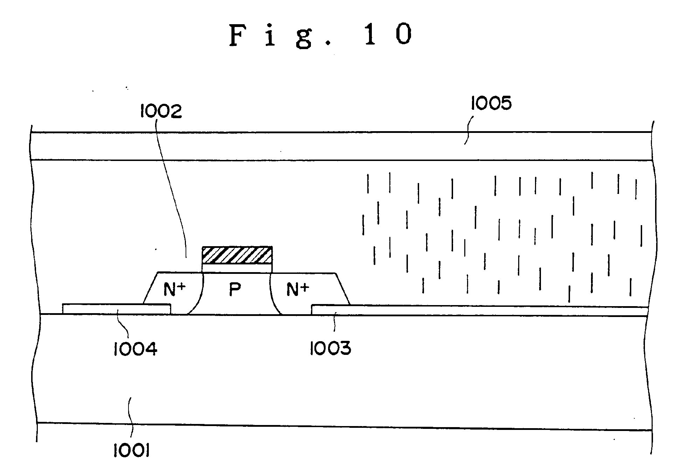

Figure 10 is a sectional view of the device showing Embodiment 8 of this invention, and this shows a MOSFET 1002 formed on a glass substrate 1001 and metal electrodes 1003 and 1004. When the transistor 1002 is turned on, the signal of the metal electrode 1004 is transmitted to the metal electrode 1003, and voltage is applied between this and the upper transparent electrode 1005. The orientation of a liquid crystal between them may change, or the signal converted to optical information by dynamic scattering. Thus, this is a display cell of a flat panel display.

Unlike a conventional transistor made of amorphous silicon, this is made of monocrystal silicon and is capable of operating at high speed. Also, the reliability of the element could be extensively improved. This makes it possible, for example, to provide a flat panel type display unit of very fine grade with a size of 30 cm X 30 cm. In such device, the driving circuit can also be fabricated from by monocrystal silicon formed on a glass substrate.

In the above embodiments, the formation of a monocrystal thin film on quartz or glass substrate has been described, whereas the materials are not limited to this. For example, film 1102 as shown of silicon nitride, SiO₂, etc. stacked on an AℓN substrate 1001 as shown in Figure 11 may be used as a substrate. On such a substrate, the heat generated from the device in high speed operation can be released effectively because it has high heat transfer properties. Naturally, solely an AℓN substrate 1101 will suffice.

Furthermore, the description has been limited to those cases where rectangular, triangular or hexagonal patterns were shown as metal pattern, but a parallel grating pattern as shown in Figure 11 (b) may be used. In Figure 11 (b), 1103 an insulating substrate, and 1104 a metal pattern. Also as the semiconductor, the description was centred mostly on Si, whereas it is needless to say that a semiconductor or a superconducting material other than Si, e.g. Ge or some other material can be applied in the same way. Of course, the actual film forming conditions would be determined separately according to each individual material or purpose.

As described above, it is possible by the method of this invention to activate the surface of a semiconductor thin film by utilising the impact of the particles having relatively low energy, to perform recrystallisation of the semiconductor and to obtain a semiconductor monocrystal thin film of good quality through a low temperature process. For example, the recrystallisation of Si can be performed at a temperature far lower than the melting point of Si, 1412°C. Accordingly, thermal strain does not occur, and problems such as contamination can be minimised. Thus, a thin film with excellent crystal properties can be obtained. Because the base material is not heated to a high temperature, the method can be easily applied to a 3-dimensional IC, which is formed by laminating the elements in many layers.

By selecting a pattern for the conductive layer having the graded steps into the desired shape, the plane orientation of the formed semiconductor monocrystal can be determined, and it is possible to control the property of the semiconductor thin film in positive and easy manner. This contributes to higher reproducibility; when it is made in a closed loop, it is possible to form the semiconductor thin film in blocks.

Further, there is no need to use an expensive substrate material such as sapphire or Si monocrystal, and a semiconductor monocrystal thin film of good quality can be obtained using an inexpensive substrate such as glass. Because a semiconductor monocrystal thin film of good quality can be obtained using any type of the insulating substrate, a remarkable effect can be obtained with low cost production.

Also, because large-sized manufacturing equipment can be produced easily, it is possible, for example, to grow monocrystal silicon on a glass substrate of several tens of square centimetres or to produce a high-performance, large-size flat panel display unit easily and at low cost by combining with a liquid crystal display.

With a semiconductor device such as a transistor manufactured by the method of this invention, ultrahigh processing speed or a considerable improvement of this property can be realised. For example, when a bipolar transistor is manufactured by the method of this invention, a very thin collector layer can be obtained. The collector electrode can be directly taken out from the lower portion by the conductive layer, and serial resistance at the collector unit can be minimised. In addition, any type of film can be formed at low temperature, and the method is most suitable for ultra-high speed bipolar LSI because no problems occur due to the distribution of the impurities. Particularly, when a metal substrate is used, serial resistance of the collector is substantially decreased, and heat resistance is also reduced. Thus, properties as a high frequency power transistor or a transistor of micro-wave or milli-wave can be considerably improved.

Also, when a MOSFET is manufactured, for example, the electrically conductive thin film used for the manufacture of the semiconductor monocrystal thin film can be used as the electrode for potential control of the substrate or for wiring. When the conductive thin film is used for the potential control of the substrate, abnormal current due to the floating effect of the substrate, as frequently seen with SOIMOSFET, can be prevented. When the conductive thin film is used as the wiring electrode, a MOSFET can be obtained, in which a current overshoot transistor and wiring of an MOM structure can be realised at the same time. This possesses two types of structure; the structure of a switching element capable of propagating ultra-high speed signals to drive the transistor at the speed as high as that of a bipolar transistor and at a low power consumption, and a wiring structure to minimise crosstalk. A device able to cope with ultra-high speed operation and having such an element and wiring structure is provided for the first time by this invention.

In summing up briefly, it is possible as the result of this invention to form easily a monocrystal semiconductor layer of high quality on any type of insulating substrate through a low temperature process and to realise the manufacture of an ultra-high speed semiconductor device, a high-performance flat panel display unit, etc. Accordingly, this invention provides a number of excellent effects compared with conventional technique.

## Claims

1. A method of manufacturing a semiconductor device which comprises forming an electrically conductive layer (102′) over at least a portion of the main surface (101′) of a substrate (101), the conductive layer (102′) defining a surface pattern including raised portions and indented portions, the junctions between the raised portions and the indented portions being in the form of a step which is generally perpendicular to the main surface of the substrate; and forming a monocrystalline silicon thin film (103) by a sputtering method on the substrate (101) while a DC potential is applied to the electrically conductive layer (102′).

2. A method as claimed in Claim 1, characterised in that the main surface of the substrate is formed with an insulating material onto which the conductive layer is applied.

3. A method as claimed in any preceding claim characterised in that the semiconductor thin film is formed by a sputtering method using an inert gas.

4. A method as claimed in Claim 1, characterised in that the main surface of the substrate is formed with a continuous electrically conductive material (702;704).

5. A method as claimed in any of Claims 1 to 3, characterised in that the conductive layer (102) is made discontinuous thereby leaving the main surface (101′) of the substrate (101) partially exposed, the conductive layer (102′) thereby forming the raised portion and the exposed parts of the substrate thereby forming the indented portions.

6. A method as claimed in Claim 5, characterised in that the conductive layer is formed as interconnected grid and the indented portions are mutually discrete.

## Patentansprüche

1. Verfahren zur Herstellung einer Halbleiteranordnung, das die Bildung einer elektrisch leitenden Schicht (102′) über mindestens einem Teil der Hauptoberfläche (101′) eines Substrates (101) umfaßt, wobei die leitende Schicht (102′) ein Oberflächenmuster definiert mit angehobenen Abschnitten und zurückgesetzten Abschnitten, und wobei Verbindungen zwischen den hervorgehobenen Abschnitten und den zurückgesetzten Abschnitten in Form einer Stufe vorliegen, die im wesentlichen senkrecht zu der Hauptfläche des Substrates ist; und Bilden eines monokristallinen Silizium-Dünnfilmes (103) auf dem Substrat (101) durch ein Zerstäubungsverfahren, während ein Gleichspannungs-potential an die elektrisch leitende Schicht (102′) angeliegt ist.

2. Verfahren nach Anspruch 1, **dadurch gekennzeichnet, daß** die Hauptoberfläche des Substrats mit einem Isoliermaterial gebildet ist, auf welchem die leitende Schicht aufgetragen wird.

3. Verfahren nach einem der vorangegangenen Ansprüche, **dadurch gekennzeichnet, daß** der Halbleiter-Dünnfilm durch ein Zerstäubungsverfahren unter Verwendung eines inerten Gases gebildet wird.

4. Verfahren nach Anspruch 1, **dadurch gekennzeichnet, daß** die Hauptoberfläche des Substrats mit einem duchgehenden, elektrisch leitendem Material (702;704) gebildet wird.

5. Verfahren nach einem der Ansprüche 1 - 3, **dadurch gekennzeichnet, daß** die leitende Schicht (102) diskontinuierlich gebildet wird, wobei die Hauptoberfläche (101′) des Substrates (101) teilweise freiliegend bleibt, und wobei die leitende Schicht (102′) dadurch den angehobenen Abschnitt und die freiliegenden Teile des Substrates dadurch die zurückgesetzten Abschnitt bilden.

6. Verfahren nach Anspruch 5, **dadurch gekennzeichnet, daß** die leitende Schicht als verbundenes Gitter gebildet wird und die zurückgesetzten Abschnitte voneinander abgesetzt sind.

## Revendications

1. Procédé pour fabriquer un dispositif semi-conducteur, comprenant la formation d'une couche électriquement conductrice (102′) sur au moins une portion de la surface principale (101′) d'un substrat (101), la couche conductrice (102′) définissant un motif de surface incluant des portions surélevées et des portions en retrait, les jonctions entre les portions surélevées et les portions en retrait étant constituées sous la forme d'un palier qui est globalement perpendiculaire à la surface principale du substrat; et la formation sur le substrat (101) d'un film mince de silicium monocristallin (103) par un procédé de pulvérisation cathodique tandis qu'un potentiel continu est appliqué à la couche électriquement conductrice (102′).

2. Procédé selon la revendication 1, caractérisé en ce que la surface principale du substrat est formée avec un matériau isolant sur lequel la couche conductrice est appliquée.

3. Procédé selon l'une quelconque des revendications précédentes, caractérisé en ce que le film mince semiconducteur est formé par un procédé de pulvérisation cathodique utilisant un gaz inerte.

4. Procédé selon la revendication 1, caractérisé en ce que la surface principale du substrat est formée avec un matériau continu électriquement conducteur (702; 704).

5. Procédé selon l'une quelconque des revendications 1 à 3, caractérisé en ce que la couche conductrice (102) est constituée de manière discontinue afin de laisser ainsi la surface principale (101′) du substrat (101) partiellement exposée, la couche conductrice (102′) formant grâce à cela la portion surélevée et les parties exposées du substrat formant grâce à cela les portions en retrait.

6. Procédé selon la revendication 5, caractérisé en ce que la couche conductrice est formée comme une grille interconnectée et les portions en retrait sont discrètes de manière réciproque.
